# EUROPEAN PATENT APPLICATION

(11) **EP 4 177 621 A1**
(43) Date of publication of application: **10.05.2023**
(21) Application number: 21207062.7
(22) Date of filing: 09.11.2021
(51) Int. Cl.: G01R 31/52, G01R 31/00, G01R 1/04, H01F 38/30, G01R 19/10, G01R 33/04, G01R 15/18

(54) **ELECTRIC CIRCUITRY FOR FAULT CURRENT DETECTION IN AN ELECTRIC VEHICLE CHARGING STATION**

(71) Applicant: eNovates, 9160 Lokeren (BE)
(72) Inventor: Vispoel, Stijn, 9040 Sint-Amandsberg (BE)
(74) Representative: IP HILLS NV

(57) **Abstract**

An electrical circuitry for detecting a fault current in an electric vehicle charging station. The electrical circuitry comprises a printed circuit board, comprising at least two conductive tracks for conducting electrical charging currents for charging and/or discharging the electric vehicle along the printed circuit board. The electrical circuitry further comprises a fluxgate current sensor for detecting a fault current in the at least two conductive tracks, comprising a magnetic core with a through-hole arranged around the at least two conductive tracks passing through the through-hole of the magnetic core.

## Description

### Field of the Invention

The present invention generally relates to an electric circuitry for detecting a fault current in an electric vehicle charging station.

### Background of the Invention

A residual current device, RCD, is a protective device designed to break an electrical circuit when a leakage current is detected, i.e. a fault current. The operation of RCDs relies on measuring the balance between the outgoing current in a live conductor and the returning current in a neutral conductor of an electrical circuit.

Thereto, typical RCDs rely on the principle of a transformer to detect the presence of a magnetic field. In a balanced electrical circuit, the magnetic field generated by each conductor in the supply line will cancel each other as their currents sum to zero. When a fault current is present however, the vectorial sum of all currents in the supply line will not be zero resulting in a detectable magnetic field around the supply line.

For safety reasons RCDs are also installed in an electric vehicle-, EV-, charging station to protect users from potential safety hazards and material damage. Type A RCDs can detect AC faults but have limited detection capabilities for fault currents with a DC component. Moreover, a fault current that contains a DC component above a certain threshold current, e.g. 6mA, can compromise the functionality of a type A RCD. As charging an EV can induce harmonics or DC residual currents, even when charging with AC, the addition of a residual direct current detection device, RDC-DD, is sometimes mandatory for EV charging stations that use a Type A RCD.

Such a RDC-DD is designed to detect a DC fault of over a certain minimum threshold current, e.g. 6mA, and can thus break the circuit before the Type A RCD becomes compromised. Alternatively, Type B RCDs can be used that detect both AC and DC faults. However, this can be substantially more expensive compared to Type A RCDs combined with a RDC-DD.

Typical RDC-DD solutions are installed inside the charging station's housing, together with the dedicated Type A RCD. Alternatively, the RCD may be installed inside the distribution switchboard that supplies power to the charging station. A problem with current RDC-DD solutions is the substantial wiring that is required to install them in a charging station. The power conductors coming from the distribution switchboard have to, at least, be connected to the charging station controller, the RDC-DD, and the EV charging socket. As this wiring needs to be performed on-site by a trained professional, it can lead to substantially high installation costs. Another challenge is that current RDC-DD solutions can have limited resolution, accuracy, linearity, and substantial noise.

### Summary of the Invention

It is an object of the present invention, amongst others, to at least partly solve the above identified challenges and problems by providing an electrical circuitry for detecting a fault current that reduces the wiring in an electric vehicle charging station.

According to a first aspect of the invention, this object is achieved by an electrical circuitry for detecting a fault current in an electric vehicle charging station. The electrical circuitry comprising a printed circuit board, comprising at least two conductive tracks for conducting electrical charging currents for charging and/or discharging the electric vehicle along the printed circuit board. The electrical circuitry further comprises a fluxgate current sensor for detecting a fault current in the at least two conductive tracks comprising a magnetic core with a through-hole arranged around the at least two conductive tracks passing through the through-hole of the magnetic core.

In other words, the fluxgate current sensor is arranged around the conductive tracks provided onto the printed circuit board. In the context of the present application, the term 'fault current' refers to any unintended and/or uncontrolled electrical current flow above a certain threshold through the at least two conductive tracks, e.g. a residual current, a leakage current, or a short-circuit current.

The at least two conductive tracks are provided onto or within the printed circuit board of the electric vehicle charging station, e.g. as strips of a conducting material included within or on the surface of the printed circuit board. An electric charge can be conducted along the at least two conductive tracks in the form of an electrical charging current. The electrical charging current can be provided to an electric vehicle connected to the electric vehicle charging station. The charging current then runs along the conductive tracks for charging the electric vehicle. The electrical charging current may be alternating current, AC, or direct current, DC, supplied to the electric vehicle charging station by an electric power source, e.g. a local electrical grid, a utility grid, a solar panel installation, or an energy storage system. The electrical charging current may also flow in an inverse direction, i.e. from the electric vehicle towards the electric power source, thereby discharging the electric vehicle along the at least two conductive tracks. The printed circuit board may, but need not be further configured to control one or more functions related to the operation of the electric vehicle charging station, e.g. monitor and/or control the charging process.

In addition to the at least two conductive tracks, a fluxgate current sensor is integrated on the printed circuit board to detect a fault current in said at least two conductive tracks. Thereto, the fluxgate current sensor includes a magnetic core with a through-hole. A cross section of the through-hole can preferably be substantially shaped as an ellipse, a stadium, a rectangle, a square, or a circle. The fluxgate current sensor is then positioned on the printed circuit board such that the magnetic core is arranged around the at least two conductive tracks. In other words, the at least two conductive tracks are passed through the through-hole of the magnetic core. Therefore, the fluxgate current sensor, in particular the magnetic core, can also be arranged around a portion of the printed circuit board surface, which includes said at least two conductive tracks.

The fluxgate current sensor is configured to detect a fault current flowing along the at least two conductive tracks, i.e. through the through-hole of the magnetic core, based on a magnetic field bias in the magnetic core due to said fault current. Integration of the fluxgate current sensor onto the printed circuit board allows the at least two conductive tracks to be integrated onto or within the printed circuit board. A fault current can thus be detected in the at least two conductive tracks without additional wiring or connections. It is thus an advantage that the number of wiring connections inside the electric vehicle charging station can be reduced. It is a further advantage that the reliability and safety of the electric vehicle charging station can be improved by a reduced number of junctions, e.g. soldered connections and screwed connections, in the main current path wiring. As such junctions are generally a point where defects, overheating, and fire may occur. It is a further advantage that the installation cost of the electric vehicle charging station can be reduced. It is a further advantage that fault currents can be detected more reliably, as fluxgate current sensors have a relatively high linearity, high accuracy, high sensitivity, low drift, and low noise.

According to an embodiment, the magnetic core can comprise a single piece of continuous magnetic material arranged around the through-hole. In other words, the ends of the magnetic material may join to form an endless loop arranged around the through-hole. The magnetic material may preferably be a material with a substantially high magnetic permeability, for example from about 1.26E-02 H/m to about 1.88 H/m, preferably around 1.26E-01 H/m, in particular a ferromagnetic material. It is a further advantage that a fault current can be detected more accurately, as the magnetic field in the single piece of continuous magnetic material can substantially include the magnetic field lines produced by the electrical current in the at least two conductive tracks.

According to an embodiment, a portion of the printed circuit board can be configured such that the fluxgate current sensor can be moved over the portion of the printed circuit board to a designated position. A portion of the printed circuit board may for example be sufficiently narrow such that said portion can be passed through the through-hole of the fluxgate current sensor, thereby bringing the fluxgate current sensor into the designated position. This can reduce the mechanical forces exerted on the magnetic core during assembly and/or manufacturing of the electrical circuitry. It is a further advantage that the operation of the fluxgate current sensor can be more reliable, as the properties of the magnetic core, in particular the magnetic permeability, are not altered due to mechanical forces during assembly or manufacturing.

According to an embodiment, the fluxgate current sensor can further comprise a protective housing enclosing at least part of the magnetic core, configured to protect the magnetic core from stress. The protective housing may cover an outer surface, an inner surface, and/or at least one side surface of the magnetic core. The protective housing may be made of a substantially rigid material as to shield the enclosed magnetic core from mechanical stress, e.g. compression, tension, or bending. The protective housing may further include a filler made of an energy absorbing material, e.g. rubber or foam. The protective housing may further be configured to protect the magnetic core from thermal stress, e.g. a protective housing made of a thermal insulating material and/or by means of a thermal insulation layer. It is a further advantage that the operation of the fluxgate current sensor can be more reliable, as the properties of the magnetic core, in particular the magnetic permeability, are not altered due to stress such as variations in ambient temperature. It is a further advantage that the fluxgate current sensor can be integrated substantially compactly on the printed circuit board, as the protective housing can electrically insulate the magnetic core from the enclosed at least two conductive tracks.

According to an embodiment, the fluxgate current sensor and printed circuit board can comprise at least one attachment means for attaching the fluxgate current sensor to the printed circuit board. The fluxgate current sensor may thus be attached to the printed circuit board, in particular in a designated position. The at least one attachment means of the fluxgate current sensor may preferably be included in the protective housing, e.g. at opposing ends of said protective housing, on the inner surface of said protective housing, and/or along an attachment leg extending from said protective housing. The printed circuit board can comprise at least one corresponding attachment means, configured to receive the at least one attachment means of the fluxgate current sensor. By the attachment means, the position of the magnetic core is fixed with respect to the conductors allowing for an efficient and repeatable measurement of the fault current.

According to an embodiment, the fluxgate current sensor can further comprise at least two excitation windings wound around the magnetic core. In other words, the at least two excitation windings can form a coil around the magnetic core. Preferably, the at least two excitation windings alternate each other such that the at least two windings succeed each other in a regular pattern. The at least two excitation windings can be configured to conduct an excitation signal, e.g. a voltage signal or a current signal, such that the magnetic core is driven into and out of saturation.

According to an embodiment, the fluxgate current sensor can further comprise a magnetic shield, partially enclosing the magnetic core and the at least two excitation windings, configured to distribute a magnetic field produced by a current in the at least two conductive tracks substantially uniform within the magnetic core. The magnetic shield may be arranged around an outer surface, an inner surface, and/or at least one side surface of the magnetic core. By partially enclosing the magnetic core, a magnetic short circuit is prevented. In doing so, the detected magnetic field in the magnetic core, produced by the outgoing and returning electrical charging current in the at least two conductive tracks, can be substantially null in the absence of a fault current, in particular if said at least two conductive tracks are distributed substantially asymmetrically within the through-hole of the fluxgate current sensor. Additionally, the magnetic shield can reduce the magnetic interference of other electrical components included on the printed circuit board and/or in the electric vehicle charging station.

According to an embodiment, the fluxgate current sensor can further comprise a driving circuitry configured to alternately drive one of the at least two excitation windings with an excitation voltage of opposite polarity and substantially equal magnitude. The driving circuitry can include a plurality of electronic components configured to operate the fluxgate current sensor by for example, amongst others, generating an excitation signal and measuring a response signal in the at least two excitation windings. The excitation signal may preferably be a square wave voltage signal. An excitation voltage may be applied to a first excitation winding, thereby driving the magnetic core into saturation. Upon reaching the saturation point, the excitation voltage can be switched from the first excitation winding to a second excitation winding. The second excitation winding may preferably be connected to the driving circuitry in parallel and with reversed polarities relative to the first excitation winding, i.e. connected in anti-parallel to the first excitation winding. As such the fluxgate current sensor can be driven by a substantially symmetric excitation signal, which can reduce measurement errors of the fluxgate current sensor.

According to an embodiment, the driving circuitry is further configured to generate an output signal based on the presence of a fault current in the at least two conductive tracks. The driving circuitry can for example generate an output signal if the fluxgate current sensor detects a fault current flowing through the at least two conductive tracks. The output signal may further trigger protective measures, e.g. interrupting the electrical charging current. These protective measure may, but need not be carried out by the electric circuitry.

According to an embodiment, the driving circuitry is further integrated on the printed circuit board. The electronic components of the driving circuitry may thus be electrically interconnected and/or connected to the fluxgate current sensor by conductive tracks included in the printed circuit board.

According to an embodiment, the electrical circuitry can further comprise a switch configured to interrupt the electrical charging current in the at least two conductive tracks upon detecting the fault current in the at least two conductive tracks. The switch may be an electrically operated switch, e.g. a relay or a circuit breaker. The switch may interrupt the electrical charging current based on an output signal received from the driving circuitry.

According to a second aspect, the invention relates to an electric vehicle charging station comprising the electrical circuitry to detect a fault current according to the first aspect. Such an electric vehicle charging station can provide one or more of the above-mentioned advantages.

### Brief Description of the Drawings

Fig. 1 shows a schematic representation of an electric vehicle charging station comprising an electric circuitry according to an aspect of the invention;
Fig. 2 shows a perspective view on a preferred embodiment of the electrical circuitry for detecting a fault current in an electric vehicle charging station of Fig. 1;
Fig. 3A and Fig. 3B respectively show a perspective view and a cross sectional view on a preferred embodiment of the fluxgate current sensor included in the electric circuitry of Fig. 2;
Fig. 4A shows a time-varying excitation voltage that can drive the fluxgate current sensor and a resulting time-varying current response;
Fig. 4B shows an example of a magnetic hysteresis loop that relates the magnetic flux density B of a magnetic core to the surrounding magnetic field strength H; and
Fig. 4C shows a duty cycle of the excitation voltage in the presence and the absence of a fault current.

### Detailed Description of Embodiment(s)

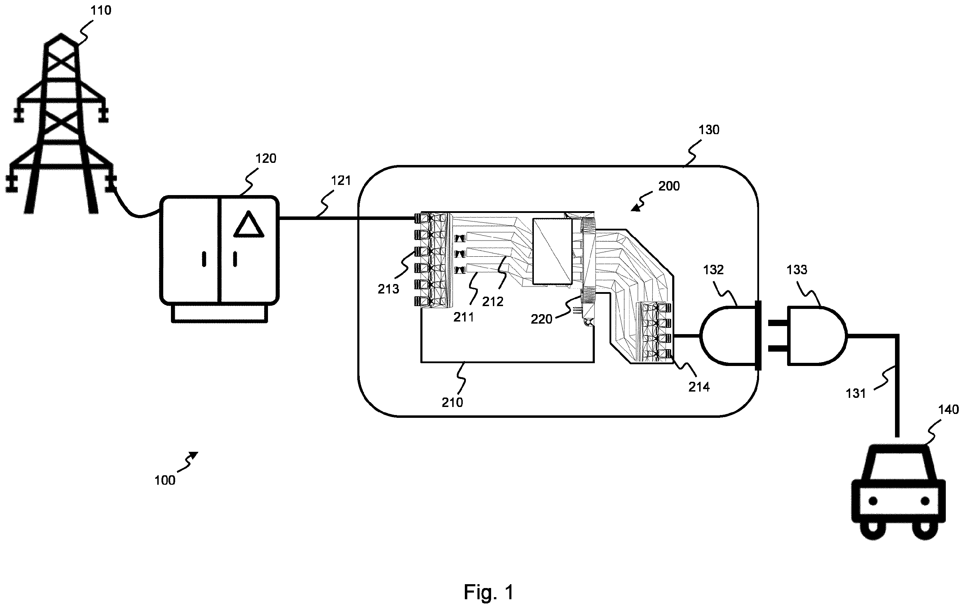

Fig. 1 shows a schematic representation 100 of an electric vehicle charging station 130 according to an example embodiment connected to a power source 110 and an electric vehicle 140. The electric vehicle charging station 130, further referred to as a charging station, is a device that charges electric vehicle 140 with energy from the power source 110. Alternatively or complementary, the charging station can discharge energy stored in the electric vehicle 140 to the power source 110. An electric vehicle 140 is a vehicle having an energy storage system, e.g. a battery. An electrical vehicle may for example be a battery powered electric car, a hybrid electric car, an electric bus, an electric truck, or an electric motorcycle. The electric vehicle 140 may be charged through an electrical connection between the vehicle 140 and the charging station 130. Such connection may be established by a charging cable 131 or an electric current collector (not shown in Fig. 1), thereby providing conductive charging. Alternatively, the electric vehicle 140 may be charged wirelessly, i.e. through inductive charging (not shown in Fig. 1).

The electrical charging current may be supplied to the charging station 130 by an electric power source 110, e.g. a local electrical grid, a utility grid, a solar panel installation, or an energy storage system. The electrical charging current may be alternating current, AC, or direct current, DC. The electric charging current may, but need not be converted at least once between AC and DC along the path from the power source 110 to the electric vehicle 140. The electrical charging current may also flow in an inverse direction, i.e. from the electric vehicle 140 to the power source 110, thereby discharging the electric vehicle. A vehicle-to-grid system or a vehicle-to-home system are examples wherein the electrical charging current can flow in both directions.

The electric power source 110 may be connected to a distribution switchboard 120, i.e. a system that can divide the supplied current into subsidiary circuits while providing protective means for those circuits. The distribution switchboard may include a subsidiary circuit 121 connected to the charging station 130. The distribution switchboard 120 may further include a residual current device, e.g. a Type A residual current device, to protect the subsidiary circuit that feeds the charging station 130. Alternatively, a residual current device may be included in the charging station 130.

The charging station 130 includes an electric circuitry 200 to detect a fault current and to control the operation of the charging station. The electric circuitry 200 comprises a printed circuit board 210 including at least two conductive tracks 211, 212 for conducting the electrical charging current along the printed circuit board 210. The electric circuitry 200 may for example comprise one or more connectors 213, 214 to establish and maintain electrical contact to the distribution switchboard 120 and the electric vehicle 140. A first connector 213 may be configured to connect the at least two conductive tracks 211, 212 of the electric circuitry 200 to the subsidiary circuit 121 of the distribution switchboard 120. A second connector 214 may be configured to connect the at least two conductive tracks 211, 212 of the electric circuitry 200 to the electric vehicle 140, e.g. through a socket 132 configured to receive the plug 133 of a charging cable 131.

The electric circuitry 200 further comprises a fluxgate current sensor 220 for detecting a fault current in the at least two conductive tracks 211, 212. In particular, the electric circuitry 200 may be configured to detect a fault current that can impede the function of a residual current device, e.g. a fault current that comprises a DC component above a certain threshold current. Upon detecting such a fault current, the electric circuitry 200 may trigger protective measures, e.g. interrupting the electrical charging current. These protective measures may, but need not be carried out by the electric circuitry 200. Alternatively, the protective measures can be carried out by other components included in the charging station 130, components included in the distribution switchboard 120, or the electric vehicle 140.

The printed circuit board 210 may not be limited to including the electrical circuitry 200 for detecting a fault current. The printed circuit board 210 may for example further comprise components configured to, amongst others, monitor and/or control the charging process, read or scan RFID cards, arrange payments, display messages, or any other function related to the operation of the charging station. Alternatively, the charging station 130 may include one or more additional printed circuit boards comprising the components for the operation of the charging station 130.

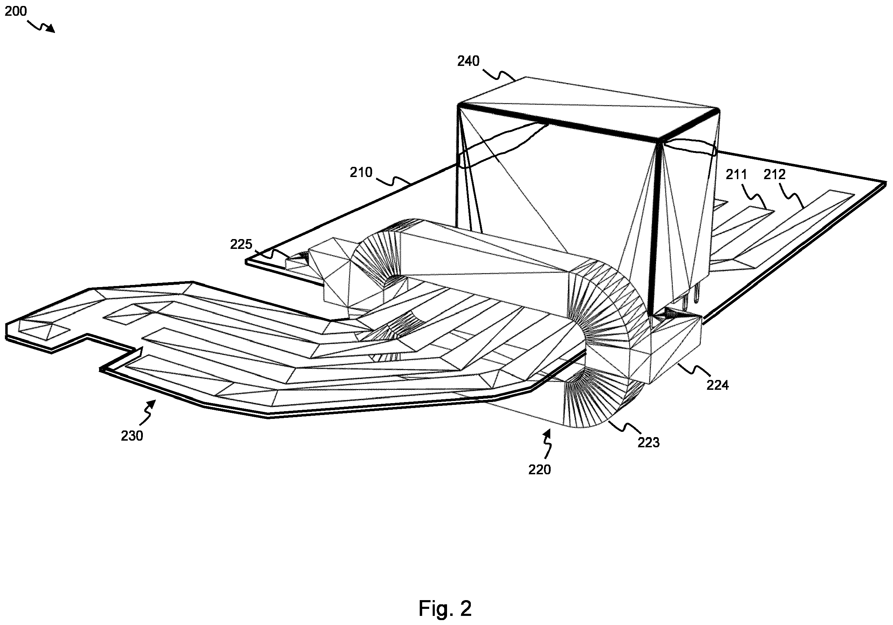

Fig. 2 shows a perspective view on a preferred embodiment of the electrical circuitry 200 for detecting a fault current in an electric vehicle charging station. A 'fault current' refers to any unintended and/or uncontrolled electrical current flow above a certain threshold through the at least two conductive tracks, e.g. a residual current, a leakage current, or a short-circuit current. A fault current may for example arise from, amongst others, a short circuit, an unintentional current interruption, a ground fault, or a short between one or more phases in a three-phase system.

The at least two conductive tracks 211, 212 are included in the printed circuit board 210 of the electric circuitry 200. The conductive tracks 211, 212 may for example be strips of conducting material such as copper, deposited on the insulating surface of a printed circuit board 210. Alternatively, the conductive tracks 211, 212 may be located within the printed circuit board 210, e.g. between two insulating layers of a multilayer printed circuit board. An electric charge, i.e. the electrical charging current, can thus be conducted along these at least two conductive tracks 211 , 212, i.e. along the printed circuit board 210. The printed circuit board may preferably include more than two conductive tracks 211, 212, in particular three or four, depending on the type of electrical current, i.e. AC or DC, and the type of electrical system, e.g. monophase, three-phase, or three-phase with a neutral wire.

To detect a fault current in the conductive tracks 211, 212, the electrical circuitry 200 comprises a fluxgate current sensor 220. The fluxgate current sensor 220 may preferably be a self-oscillating fluxgate current sensor, in particular an open-loop self-oscillating fluxgate current sensor. The fluxgate current sensor 220 includes a magnetic core made of a magnetic material. The magnetic material may preferably be a material with a substantially high magnetic permeability, for example from about 1.26E-02 H/m to about 1.88 H/m, preferably around 1.26E-01 H/m, in particular a ferromagnetic material. The magnetization of the magnetic material may be characterized by magnetic hysteresis, preferably with a relatively low saturation flux, i.e. the magnetic flux corresponding to a saturation point of the hysteresis loop. Preferably, the magnetic core may comprise a single piece of continuous magnetic material. In other words, the ends of the magnetic material may join to form an endless loop. In this case, the magnetic core does not comprise separate parts of magnetic material that require assembly to form the magnetic core. In doing so, the magnetic permeability of the magnetic core can be improved due to the absence of air gaps in the magnetic core material. As such, the magnetic field in the magnetic core can include more of the magnetic field lines produced by an electrical current in the conductive tracks 211, 212. Alternatively, the magnetic core can comprise separate parts of magnetic material that require assembly to form the magnetic core.

The magnetic core further comprises a through-hole, around which the magnetic material is arranged. The magnetic core is further arranged around the conductive tracks 211, 212, i.e. the conductive tracks pass through the through-hole of the magnetic core. A cross section of the through-hole may preferably be substantially shaped as an ellipse, a stadium, a rectangle, a square, or a circle. The cross section of the through-hole may have any other shape as long as the conductive tracks 211, 212 can be passed freely through the through-hole of the magnetic core.

The fluxgate current sensor 220 can thus be integrated on the printed circuit board such that the conductive tracks 211, 212 are passed through the through-hole of the magnetic core, i.e. the magnetic core is arranged around the conductive tracks 211, 212. As the conductive tracks 211, 212 are included in the printed circuit board 210, the fluxgate current sensor 220, in particular the magnetic core, can also be arranged around a portion of the printed circuit board 210 surface, in particular a portion of the surface that includes the conductive tracks 211, 212.

The fluxgate current sensor 220 can further comprise a protective housing 223 enclosing at least part of the magnetic core, configured to protect the magnetic core from stress, i.e. a force acting on a unit area of the magnetic core. The protective housing 223 may cover an outer surface, an inner surface, or at least one side surface of the magnetic core. The outer and inner surface of the magnetic core refer to the surface of the magnetic core respectively facing away and facing towards the centreline of the magnetic core. The side surface of the magnetic core refers to a lateral surface substantially transverse to the outer and inner surface of the magnetic core.

To shield the magnetic core from mechanical stress, e.g. compression, tension, or bending, the protective housing 223 may be made from a substantially rigid material, i.e. a material substantially unable to be bend or be forced out of shape. Alternatively or complementary, the protective housing 223 may include an energy absorbing material such as for example rubber or foam, i.e. a material that can deform elastically to absorb at least part of the mechanical stress. This energy absorbing material may for example be included in the protective housing 223 as an additional inner layer between the outer layer of the housing and the magnetic core. Alternatively, the enclosed volume of the protective housing 223 may for example be filled with a filler, thereby enclosing the entire magnetic core. In addition to mechanical stress, the protective housing 223 may shield the magnetic core from thermal stress by for example including a layer or filler made of a thermal insulating material.

The printed circuit board 210 can further comprise a portion 230 configured such that the fluxgate current sensor 220 can be moved over the portion to a designated position. The portion 230 can thus be configured to allow substantially free movement of the fluxgate current sensor 220 along the portion 230, towards the designated position. The designated position refers to a position on the printed circuit board 210 where the fluxgate current sensor 220 can detect a fault current in the conductive tracks 211, 212. To move the fluxgate current sensor 220 to this position, the portion 230 can be shaped according to the shape and dimensions of the through-hole in the magnetic core. The portion 230 of the printed circuit board may for example be sufficiently narrow such that it can be passed through the through-hole of the fluxgate current sensor 220, thereby bringing the fluxgate current sensor into the designated position. As such, the printed circuit board 210 can receive the fluxgate current sensor 220, even if the magnetic core comprises a single piece of continuous magnetic material. By allowing substantially free movement of the fluxgate current sensor 220, the mechanical forces on the fluxgate current sensor during manufacturing or assembly of the electrical circuitry can be reduced. Mechanical forces on the fluxgate current sensor may be undesirable as they can alter the mechanical and/or magnetic properties of the magnetic core, thereby affecting the performance of the fluxgate current sensor 220.

The fluxgate current sensor 220 can further be attached to the printed circuit board 210, in particular in the designated position. To this end, the fluxgate current sensor 220 and the printed circuit board 210 can comprise at least one attachment means. The at least one attachment means of the fluxgate current sensor 220 may preferably be included in the protective housing 223, e.g. at opposing ends of said protective housing, on the inner surface of said protective housing, and/or along an attachment leg 224, 225 extending from the protective housing 223._The attachment means may for example be, amongst others, retainers, screws, bolts, rivets, grommets, plugs, pins, snap fasteners, snap fits or any other attachment means known to the person skilled in the art. The printed circuit board 210 can comprise at least one corresponding attachment means, configured to receive the attachment means of the fluxgate current sensor 220. The attachment means may further provide a releasable or permanent connection to the printed circuit board 210.

The electrical circuitry 200 can further comprise a switch 240 configured to interrupt the electrical current in the conductive tracks 211, 212 upon detection of a fault current, in particular a fault current that can impede the function of a residual current device, e.g. a fault current that comprises a DC component above a certain threshold current. Preferably, the switch can be triggered by a fault current above an adjustable threshold current, e.g. 6mA. The switch 240 may be an electrically operated switch such as for example a relay, a circuit breaker, or any other switch known to the person skilled in the art. The switch 240 may preferably be included, i.e. integrated, on the printed circuit board 210. Alternatively, the switch 240 may be provided somewhere else in the charging station, i.e. not included on printed circuit board 210. The switch 240 may be controlled by a signal received from the fluxgate current sensor 220 upon detection of a fault current.

It is to be understood that Fig. 2 does not show all components of the printed circuit board 210. The printed circuit board 210 may further_include a plurality of electronic components to control the operation of the charging station, to connect the printed circuit board 210 to other components, to test the correct and safe operation of the flux gate sensor, and/or to detect a fault current. Such electronic components may for example include, amongst others, resistors, connectors, transistors, capacitors, control units, comparators, multivibrators, operational amplifiers, switches, voltage sources, or current sources.

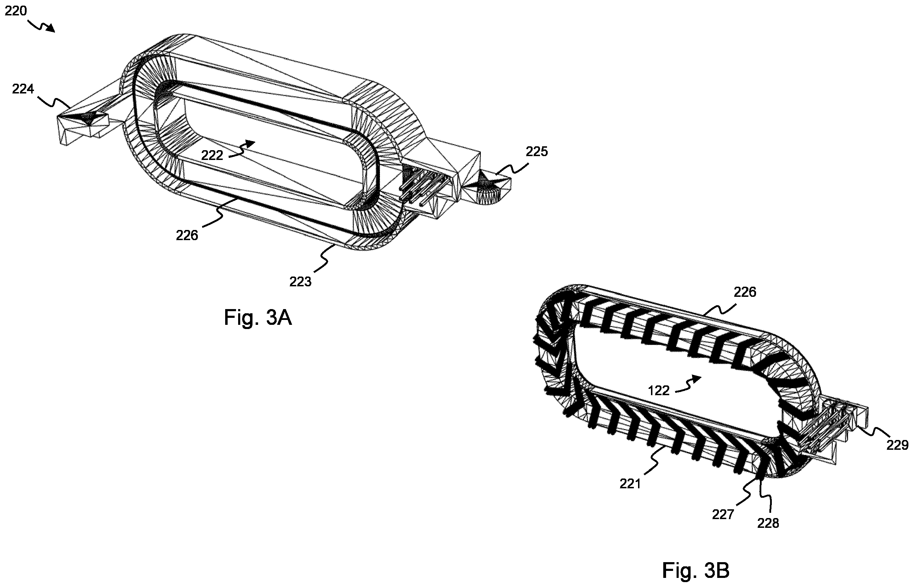

Fig. 3A and Fig. 3B respectively show a perspective view and a cross sectional view on a preferred embodiment of the fluxgate current sensor. In addition to being enclosed by the protective housing 223, the magnetic core 221 may further be partially enclosed by a magnetic shield 226. The magnetic shield 226 may be arranged around an outer surface, an inner surface, at least one side surface of the magnetic core 221, or any combination thereof, as long as the magnetic shield 226 does not surround the magnetic core 221 on all sides. The magnetic shield 226 can distribute a magnetic field, produced by a current flowing in the conductive tracks, substantially uniform within the magnetic core 221. As such, the detected magnetic field in the magnetic core 221 can be substantially null in the absence of a fault current, in particular if the conductive tracks are distributed asymmetrically within the through-hole 222 of the fluxgate current sensor 220. In other words, the magnetic shield 226 can assist in nullifying the detected magnetic field in the magnetic core 221 in the absence of a fault current. The detected magnetic field refers to the net magnetic field seen by the magnetic core. In the absence of a fault current, the detected magnetic field may be produced by at least one outgoing and returning electrical charging current of substantial equal magnitude, flowing in substantial opposite directions in the at least two conductive tracks through the through-hole 222 of the magnetic core 221. Additionally, the magnetic shield 221 can reduce the magnetic interference of other electrical components included on the printed circuit board or in the electric vehicle charging station.

The fluxgate current sensor 220 may comprise at least two excitation windings 227, 228 wound around the magnetic core 221. In other words, the excitation windings 227, 228 can form a coil that is wound around magnetic core 221. Preferably, the at least two excitation windings 227, 228 alternate each other such that they follow and succeed each other in a regular pattern. The excitation winding 227, 228 may be an electrical conductor, such as for example an insulated copper wire, configured to conduct an excitation signal. The excitation signal may be any signal that drives the magnetic core into and out of saturation, e.g. a current signal or a voltage signal. Preferably, the magnetic shield 226 may enclose these excitation windings 227, 228 in addition to enclosing the magnetic core 221.

The excitation windings 227, 228 may further be connected to a driving circuitry, e.g. through a connector 229. The driving circuitry may include a plurality of electronic components such as for example, amongst others, a comparator, a multivibrator, an operational amplifier, a switch, a voltage source, or a current source. Preferably, the driving circuitry may be integrated on the printed circuit board. In other words, the electronic components of the driving circuitry may be electrically interconnected by conductive tracks on the printed circuit board, in addition to being connected to the excitation windings 227, 228 through connector 229. The driving circuitry may be configured to operate the fluxgate current sensor 220 by for example, amongst others, generating an excitation signal and measuring a response signal. Preferably, the excitation signal may be an excitation voltage and the response signal may be the current flowing through the excitation windings 227, 228 as a result of the applied excitation voltage.

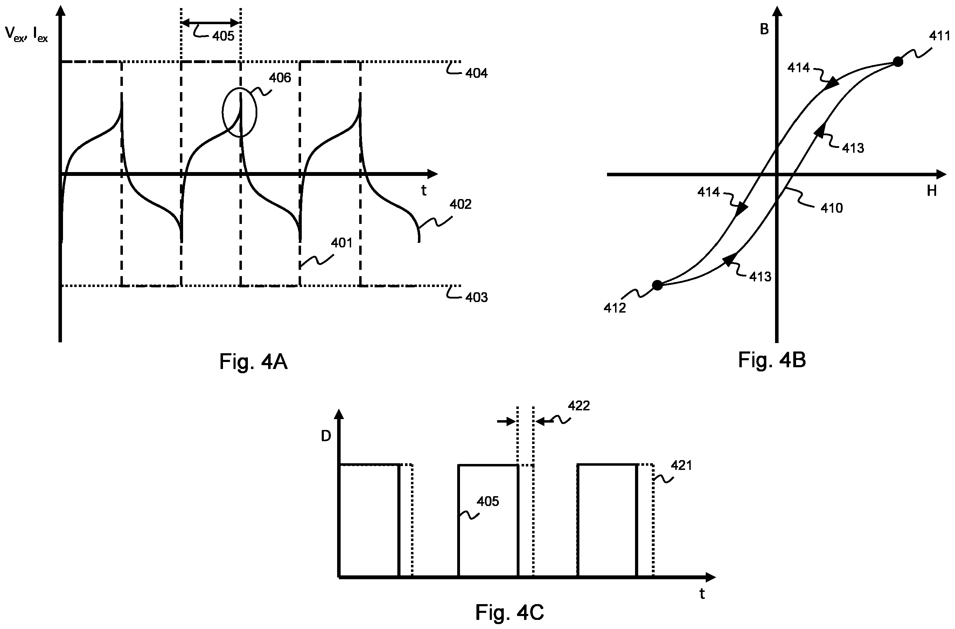

Fig 4A shows an example of such a time-varying excitation voltage 401 and the resulting time-varying current response 402. The excitation voltage 401, generated by the electronic components of the driving circuitry, may preferably be a square wave signal. In other words, the excitation voltage 401 may switch between a predetermined minimum 403 and maximum 404 value at a substantial steady frequency, with a substantial equal duration, i.e. duty cycle 405, at the minimum 403 and maximum 404 voltage. The minimum 403 and maximum 404 voltage may preferably be of substantially equal magnitude and opposite polarity, e.g. -3.5V and 3.5V respectively. The fluxgate current sensor can thus be driven by a substantially symmetric excitation voltage 401, which can reduce measurement errors of the fluxgate current sensor.

To obtain such a substantially symmetric excitation voltage in a reliable way, the excitation windings may be connected to the driving circuitry in parallel and with reversed polarities, i.e. in anti-parallel. The driving circuitry can thus alternatingly apply the same voltage, e.g. 3.5V, to a first excitation winding and a second excitation winding, wherein the polarity of the voltage can be reversed due to the anti-parallel connection of the excitation windings. In other words, the minimum 403 and maximum 404 voltage can be applied to respectively a first and a second excitation winding, thereby exposing the magnetic core of the fluxgate current sensor to a substantially symmetric square voltage wave.

The applied excitation voltage 401 may result in a time-varying current response 402, flowing through the excitation windings. This current response 402 can be measured by the driving circuitry, e.g. by a shunt or a precision resistor. The response current 402 can drive the magnetic core into saturation, as the core may be characterized by magnetic hysteresis. Fig. 4B shows an example of a magnetic hysteresis loop 410 that relates the magnetic flux density B within the magnetic core to the surrounding magnetic field strength H. The magnetic flux density B refers to a measure of the actual magnetic field within the magnetic core material, considered as a concentration of magnetic field lines, or flux, per unit cross-sectional area. The magnetic field strength H refers to a measure of the magnetizing field produced by a nearby electrical current flowing in a conductor, e.g. in the conductive tracks or the excitation windings. A magnetic hysteresis loop may further be characterized by a positive saturation point 411 and a negative saturation point 412. In such a saturation point 411, 412 a change in magnetic field strength H no longer results in a substantial change of the magnetic flux density B. In other words, a saturation point 411, 412 can be understood as the point where the magnetic core is saturated with magnetic field lines.

When for example a positive excitation voltage 401 is applied to a first excitation winding, the resulting current 402 can produce a magnetic field. The resulting change in magnetic field strength H will change the magnetic flux density B in the magnetic core, according to hysteresis loop 410. In turn, the changing magnetic flux density B in the magnetic core can influence the response current 402, e.g. by a counter-electromotive force, a varying impedance of the excitation winding, and a varying inductance of the excitation winding. During one duty cycle 405, the current response 402 can for example evolve to a maximum value, thereby driving 413 the magnetic core to the positive saturation point 411. Upon reaching saturation, the impedance and inductance of the excitation winding can drop substantially thus resulting in a current spike 406. The driving circuitry may be configured to detect the current spike 406 and, upon detection of the current spike 406, to switch the excitation voltage 401 to a second excitation winding, anti-parallel to the first winding. As such, the polarity of the excitation voltage 401 can substantially instantaneously be reversed and a following duty cycle can be initiated. This will cause the current response 402 to decrease from the maximum value to a minimum value and hence, drive 414 the magnetic core out of the positive saturation point 411 to the negative saturation point 412. Upon reaching the negative saturation point 412, another current spike can be detected by the driving circuitry, followed by switching the excitation voltage 401 back to the first excitation winding.

In the absence of a fault current, the outgoing and returning electrical charging current flowing through the conductive tracks of the electric circuitry may be of substantial equal magnitude. As such, the magnetic field produced by each conductive track will cancel each other. The response current 402 can thus be substantially symmetrical and the excitation voltage 401 may switch between a predetermined minimum 403 and maximum 404 value at a steady frequency with a substantial equal duration. In other words, the duty cycle 405 of the maximum 404 or minimum 404 excitation voltage 401 may be substantially symmetric, i.e. 50%, in the absence of a fault current, as shown in Fig. 4C.

When a fault current is flowing through the conductive tracks of the electric circuitry, a magnetic field bias may be imposed on the magnetic core. The magnetic field bias can offset the magnetic hysteresis loop 410, thereby resulting in a substantially asymmetric response current 402 and excitation voltage 401. In other words, a duty cycle 421 of the maximum 404 or minimum 404 excitation voltage 401 may be substantially asymmetric, i.e. higher or lower than 50%. The offset 422 from the symmetric duty cycle 405, i.e. the offset from 50%, can be related to the magnitude of the fault current. In other words, the fluxgate current sensor can detect and measure a fault current based on the offset 422 of the excitation voltage duty cycle 421 in the presence of a fault current, compared to the symmetric duty cycle 405 in the absence of a fault current.

The driving circuitry can be configured to determine the offset 442 of the duty cycle, thereby detecting the presence of a fault current in the conductive tracks. The driving circuitry may further be configured to generate an output signal based on the presence of a fault current in the conductive tracks. The driving circuitry can for example generate an output signal upon detection of a fault current that can impede the function of a residual current device, e.g. a fault current that comprises a DC component above a certain threshold current. Preferably, the threshold current that triggers such an output signal can be adjusted by the driving circuitry. The output signal may further trigger protective measures such as interrupting the electrical charging current. To this end, the output signal may preferably be communicated to the integrated switch of the electric circuitry such that it can interrupt the electrical charging current. Alternatively or complementary, the output signal may be communicated to other components included in the charging station, components included in the distribution switchboard, or the electric vehicle.

Although the present invention has been illustrated by reference to specific embodiments, it will be apparent to those skilled in the art that the invention is not limited to the details of the foregoing illustrative embodiments, and that the present invention may be embodied with various changes and modifications without departing from the scope thereof. The present embodiments are therefore to be considered in all respects as illustrative and not restrictive, the scope of the invention being indicated by the appended claims rather than by the foregoing description, and all changes which come within the meaning and range of equivalency of the claims are therefore intended to be embraced therein. In other words, it is contemplated to cover any and all modifications, variations or equivalents that fall within the scope of the basic underlying principles and whose essential attributes are claimed in this patent application. It will furthermore be understood by the reader of this patent application that the words "comprising" or "comprise" do not exclude other elements or steps, that the words "a" or "an" do not exclude a plurality, and that a single element, such as a computer system, a processor, or another integrated unit may fulfil the functions of several means recited in the claims. Any reference signs in the claims shall not be construed as limiting the respective claims concerned. The terms "first", "second", third", "a", "b", "c", and the like, when used in the description or in the claims are introduced to distinguish between similar elements or steps and are not necessarily describing a sequential or chronological order. Similarly, the terms "top", "bottom", "over", "under", and the like are introduced for descriptive purposes and not necessarily to denote relative positions. It is to be understood that the terms so used are interchangeable under appropriate circumstances and embodiments of the invention are capable of operating according to the present invention in other sequences, or in orientations different from the one(s) described or illustrated above.

As used in this application, the term "circuitry" may refer to one or more or all of the following: (a) hardware-only circuit implementations (such as implementations in only analog and/or digital circuitry) and (b) combinations of hardware circuits and software, such as (as applicable): (i) a combination of analog and/or digital hardware circuit(s) with software/firmware and (ii) any portions of hardware processor(s) with software (including digital signal processor(s)), software, and memory(ies) that work together to cause an apparatus to perform various functions) and (c) hardware circuit(s) and or processor(s), such as a microprocessor(s) or a portion of a microprocessor(s), that requires software (e.g., firmware) for operation, but the software may not be present when it is not needed for operation. This definition of circuitry applies to all uses of this term in this application, including in any claims. As a further example, as used in this application, the term circuitry also covers an implementation of merely a hardware circuit or processor (or multiple processors) or portion of a hardware circuit or processor and its (or their) accompanying software and/or firmware.

## Claims

1. An electrical circuitry (100) for detecting a fault current in an electric vehicle charging station, comprising:
- a printed circuit board (110) comprising at least two conductive tracks (111) for conducting electrical charging currents for charging and/or discharging the electric vehicle along the printed circuit board; and
- a fluxgate current sensor (120) for detecting a fault current in the at least two conductive tracks comprising a magnetic core (121) with a through-hole (122) arranged around the at least two conductive tracks passing through the through-hole of the magnetic core.

2. The electrical circuitry according to claim 1, wherein the magnetic core (121) comprises a single piece of continuous magnetic material arranged around the through-hole (122).

3. The electrical circuitry according to any of the preceding claims, wherein a portion of the printed circuit board (110) is configured such that the fluxgate current sensor (120) can be moved over the portion of the printed circuit board to a designated position.

4. The electrical circuitry according to any of the preceding claims, wherein the fluxgate current sensor further comprises a protective housing (123) enclosing at least part of the magnetic core (121), configured to protect the magnetic core from stress.

5. The electrical circuitry according to any of the preceding claims, wherein the fluxgate current sensor (120) and printed circuit board (110) comprise at least one attachment means (124, 125) for attaching the fluxgate current sensor to the printed circuit board.

6. The electrical circuitry according to any of the preceding claims, wherein a cross section of the through-hole (122) is substantially shaped as an ellipse, a stadium, a rectangle, a square, or a circle.

7. The electrical circuitry according to any of the preceding claims, wherein the fluxgate current sensor further comprises at least two excitation windings (127, 128) wound around the magnetic core (121).

8. The electrical circuitry according to claim 8, wherein the at least two excitation windings (127, 128) alternate each other.

9. The electrical circuitry according to claim 8, wherein the fluxgate current sensor further comprises a magnetic shield (126), partially enclosing the magnetic core (121) and the at least two excitation windings (127, 128), configured to distribute a magnetic field produced by a current in the at least two conductive tracks substantially uniform within the magnetic core.

10. The electrical circuitry according to claim 8, wherein the fluxgate current sensor further comprises a driving circuitry configured to alternately drive one of the at least two excitation windings (127, 128) with an excitation voltage of opposite polarity and substantially equal magnitude.

11. The electrical circuitry according to claim 11, wherein the driving circuitry is further configured to generate an output signal based on the presence of a fault current in the at least two conductive tracks.

12. The electrical circuitry according to claim 11, wherein the driving circuitry is further integrated on the printed circuit board.

13. The electrical circuitry according to any of the preceding claims, further comprising a switch (140) configured to interrupt the electrical charging current in the at least two conductive tracks (111) upon detecting the fault current in the at least two conductive tracks.

14. An electric vehicle charging station comprising the electrical circuitry (100) to detect a fault current according to any of the preceding claims.
